# EUROPEAN PATENT SPECIFICATION

(11) **EP 4 232 870 B1**
(45) Date of publication and mention of the grant of the patent: **29.10.2025**
(21) Application number: 21884034.6
(22) Date of filing: 22.10.2021
(51) Int. Cl.: G02F 1/133, B60L 53/16, B60K 35/22, B60L 53/302, B60L 53/30, G06F 1/20, B60L 53/31, G02F 1/1333, G09F 9/30, G09F 9/35, G09F 21/04, H05K 7/20

(54) **FORCED AIR COOLING FOR DISPLAY ASSEMBLIES**
ZWANGSLUFTKÜHLUNG FÜR ANZEIGEANORDNUNGEN
REFROIDISSEMENT PAR CIRCULATION D'AIR FORCÉE POUR ENSEMBLES D'AFFICHAGE

(30) Priority: 23.10.2020 US 202017078861
(43) Date of publication of application: 30.08.2023
(73) Proprietor: Manufacturing Resources International, Inc., Alpharetta, GA 30005 (US)
(72) Inventor: DUNN, William, Alpharetta, GA 30005 (US); DIAZ, Marcos, Alpharetta, GA 30005 (US); MOREAU, Alex, Alpharetta, GA 30005 (US)
(74) Representative: FRKelly
(86) International application number: PCT/US2021/056353
(87) International publication number: WO 2022/087488

(56) References cited:
- WO-A1-2014/195560
- WO-A1-2014/195560
- JP-A- 2001 249 402
- US-A1- 2016 249 493
- US-A1- 2016 249 493
- US-A1- 2017 172 016
- US-A1- 2020 205 303
- US-A1- 2020 288 585

## Description

### CROSS-REFERENCE TO RELATED APPLICATIONS

This application claims priority to U.S. Application No. 17/078,861 filed October 23, 2020.

### TECHNICAL FIELD

Exemplary embodiments relate generally to systems and methods for forced air cooling of display assemblies, such as those incorporating electric vehicle charging equipment.

### BACKGROUND AND SUMMARY OF THE INVENTION

The use of electronic displays for advertising in the out-of-home market has increased in popularity over recent years. Being located outdoors, such electronic displays are frequently exposed to harsh conditions, including but not limited to, solar loading, extreme temperatures, precipitation, moisture, contaminants, vandalism, wildlife, and the like. To protect the electronic displays and other components from such harsh conditions, it is known to place the electronic displays in fully or partially sealed housings. The harsh conditions and/or placement in such fully or partially sealed housings, may create a need to thermally manage the electronic displays. It is known to provide open and/or closed loop airflow pathways through such housings to control temperatures, thereby maintaining desirable operating conditions for the electronic displays and related components. It is known to provide back-to-back electronic displays with a common plenum, such as is provided in US Pat. No. 8,373,841 issued February 12, 2013, or a common heat exchanger, such as is provided in US Pat. No. 8,351,014 issued January 8, 2013.

Traditionally, tube axial fans are used to force such cooling through these open and/or closed loop airflow pathways, though other types of fans such as centrifugal fans have been used. What is needed is an electronic display assembly which utilizes centrifugal fans to provide forced air cooling.

Electronic display assemblies which utilize centrifugal fans to provide forced air cooling are provided. Such centrifugal fans may be utilized in one or more open loop airflow pathways, one or more closed loop airflow pathways, some combination thereof, or the like. WO 2014/195560 discloses a display assembly incorporating a charging station for an electric vehicle. US 2020/205303, US 2017/172016 and US 2016/249493 disclose known electronic display assemblies incorporating cooling fans.

The use of such centrifugal fans may provide several advantages. For example, without limitation, the design of such centrifugal fans may require that air be turned essentially 90 degrees during normal operation. Corners may be provided along the open and/or closed loop airflow pathways of display assemblies which normally provide areas of airflow resistance and/or turbulence. When deployed in such display assemblies, the centrifugal fan may be placed to essentially turn the air the 90 degrees otherwise required to complete a loop or pass through the housing. The use and engineered placement of centrifugal fans may therefore form a natural part of the open or closed loop airflow pathways and may improve airflow efficiency around such corners.

Additionally, or alternatively, such centrifugal fans may facilitate even distribution of air upon discharge. This may improve evenness of cooling, distribution, and/or airflow. For example, without limitation, the centrifugal fans may be provided without certain common shrouding components to facilitate such distribution.

As another example, without limitation, the centrifugal fans may reduce noise emission and/or utilize less power relative to other types of fans such as tube axial fans. As yet another example, without limitation, the centrifugal fans may provide the same or higher mass airflow rates for air. The use of such centrifugal fans may, for example, without limitation, result in increased homogenization of air. Such homogenization may lead to move even cooling and better temperature control of such display assemblies and related components. This may result in a reduction of the number of fans and/or the operating speed of such fans.

It may be desirable to incorporate electric vehicle ("EV") chargers into such display assemblies. Such EV chargers may be able to take advantage of established structural framework, power supplies, and/or thermal management capabilities of the display assemblies. Alternatively, or additionally, such display assemblies may be modified, such as structurally, electrically, or thermodynamically, to accommodate such EV chargers. In exemplary embodiments, advertisements, announcements, or entertaining images, to provide a few non-limiting examples, may be displayed at the subassemblies while electric vehicles are charged nearby. The present invention provides a display assembly as claimed in claim 1.

Further features and advantages of the systems and methods disclosed herein, as well as the structure and operation of various aspects of the present disclosure, are described in detail below with reference to the accompanying figures.

### BRIEF DESCRIPTION OF THE DRAWINGS

In addition to the features mentioned above, other aspects of the present invention will be readily apparent from the following descriptions of the drawings and exemplary embodiments, wherein like reference numerals across the several views refer to identical or equivalent features, and wherein:
**FIGURE 1** is a front perspective view of an exemplary display assembly not falling within the scope of the present invention;
**FIGURE 2** is a front view of the display assembly of figure 1;
**FIGURE 3** is a rear perspective view of the display assembly of figure 1 with certain components removed to illustrate other, internal components;
**FIGURE 4** is a rear perspective view of the display assembly of figure 3 with a rear cover removed to illustrate additional, internal components;
**FIGURE 5** is a rear view of another exemplary embodiment of the display assembly of figure 4;
**FIGURE 6A** is a side sectional view of the display assembly of figure 1 taken along section line A-A of figure 2;
**FIGURE 6B** is a side section view of the display assembly of figure 6A with an exemplary flow velocity profile demonstrating exemplary open loop airflow;
**FIGURE 7A** is a top sectional view of the display assembly of figure 1 taken along section line B-B of figure 2;
**FIGURE 7B** is a side section view of the display assembly of figure 7A with an exemplary flow velocity profile demonstrating exemplary closed loop airflow;
**FIGURE 8** is a front perspective view of a display assembly in accordance with an embodiment of the present invention;
**FIGURE 9** is a front view of the display assembly of figure 8;
**FIGURE 10A** is a side sectional view of the display assembly of figure 8 taken along section line C-C- of figure 9;
**FIGURE 10B** is a detailed side section view of the display assembly of figure 10A taken from detail A of figure 10A with an exemplary flow velocity profile demonstrating exemplary open loop airflow;
**FIGURE 11A** is a top sectional view of the display assembly of figure 8 taken along section line D-D of figure 9;
**FIGURE 11B** is a side section view of the display assembly of figure 11A with an exemplary flow velocity profile demonstrating exemplary closed loop airflow;
**FIGURE 12** is a front perspective view of the display assembly of figure 8 with certain components removed to illustrate certain internal components;
**FIGURE 13** is a rear perspective view of the display assembly of figure 8 with certain components removed to illustrate certain internal components;
**FIGURE 14** is a detailed rear perspective view of the display assembly of figure 8 taken from detail A of figure 13 with an exemplary flow path profile for demonstrating exemplary closed loop airflow;
**FIGURE 15A** is a plan view of an electrical schematic suitable for the display assembly of figures 1-14;
**FIGURE 15B** is a plan view of another exemplary electrical schematic suitable for the display assembly of figures 1-14;
**FIGURE 15C** is a plan view of another exemplary electrical schematic suitable for the display assembly of figures 1-14; and
**FIGURE 15D** is a plan view of another exemplary electrical schematic suitable for the display assembly of figures 1-14.

### DETAILED DESCRIPTION OF EXEMPLARY EMBODIMENT(S)

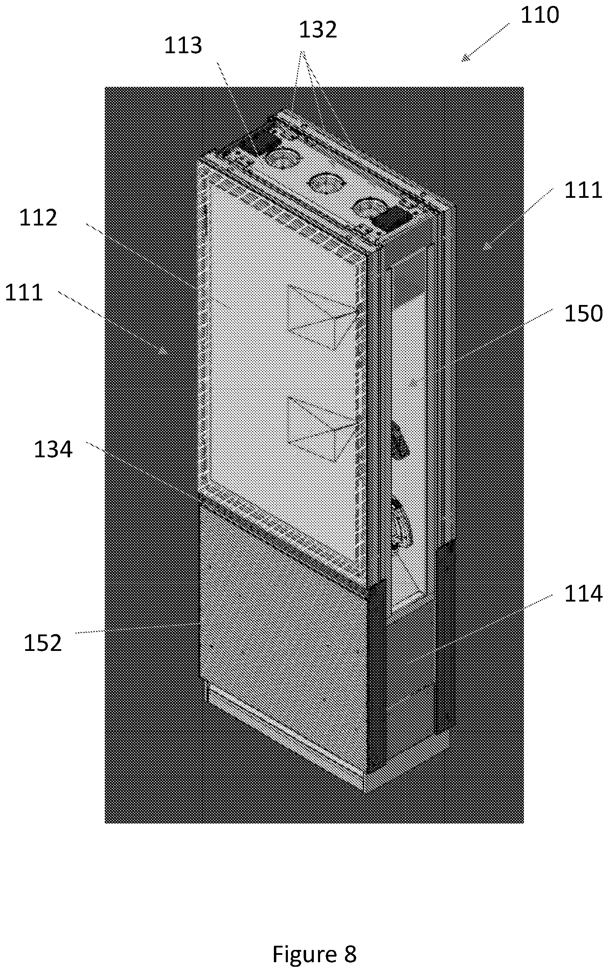

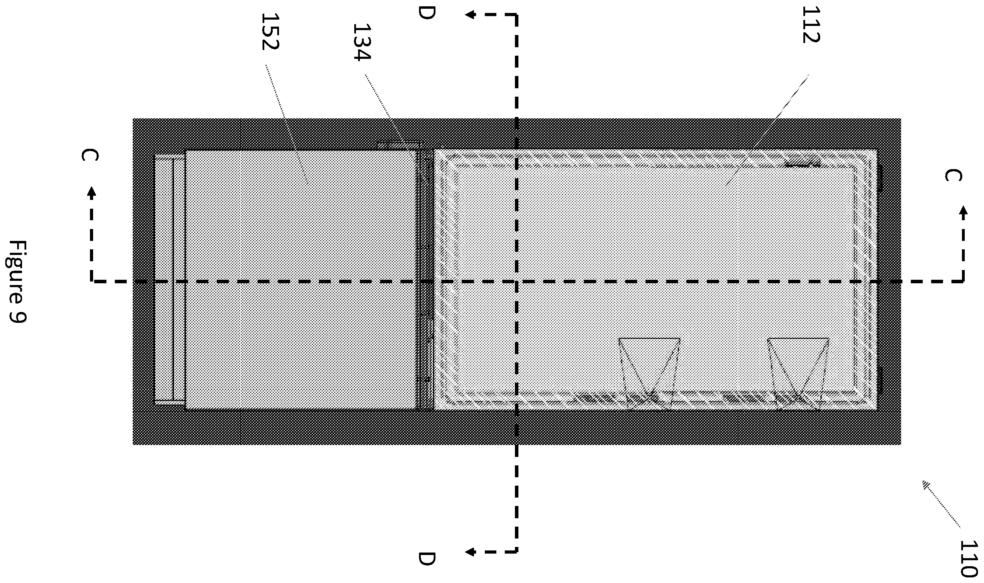

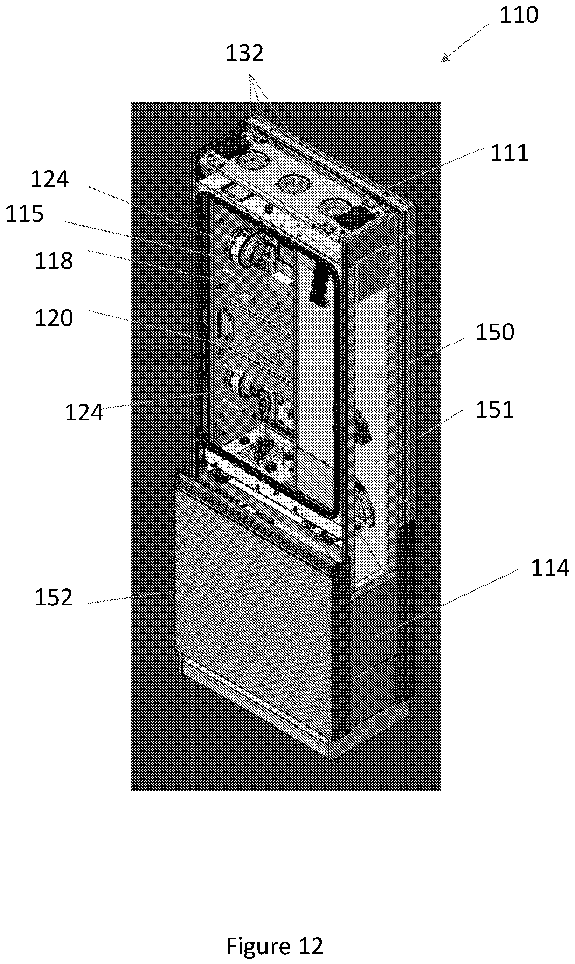

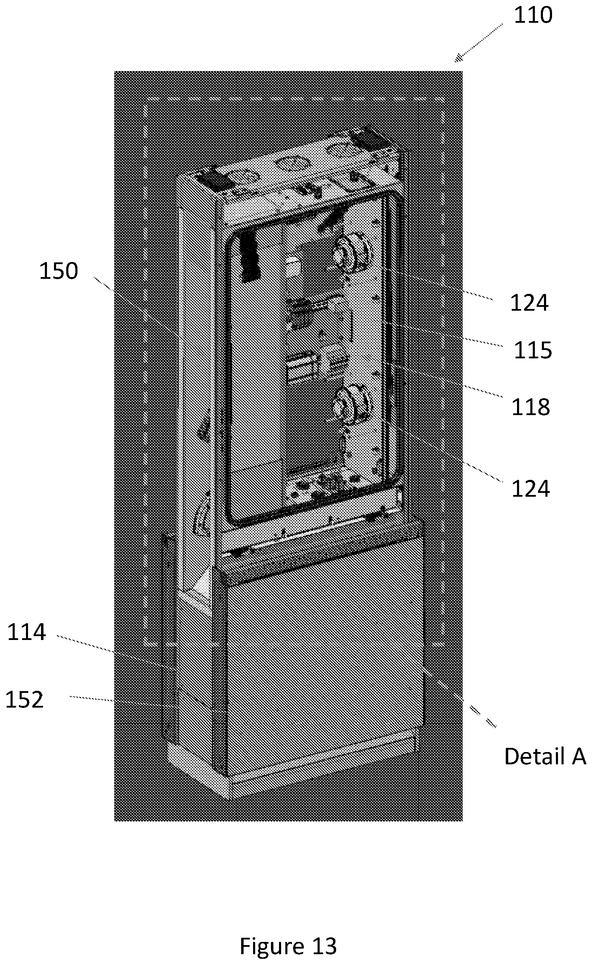

Various embodiments of the present invention will now be described in detail with reference to figures 8 to 14. In the following description, specific details such as detailed configuration and components are merely provided to assist the overall understanding of these embodiments of the present invention. Therefore, it should be apparent to those skilled in the art that various changes and modifications of the embodiments described herein can be made without departing from the scope of the present invention as defined by the claims. In addition, descriptions of well-known functions and constructions are omitted for clarity and conciseness.

Embodiments of the invention are described herein with reference to illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

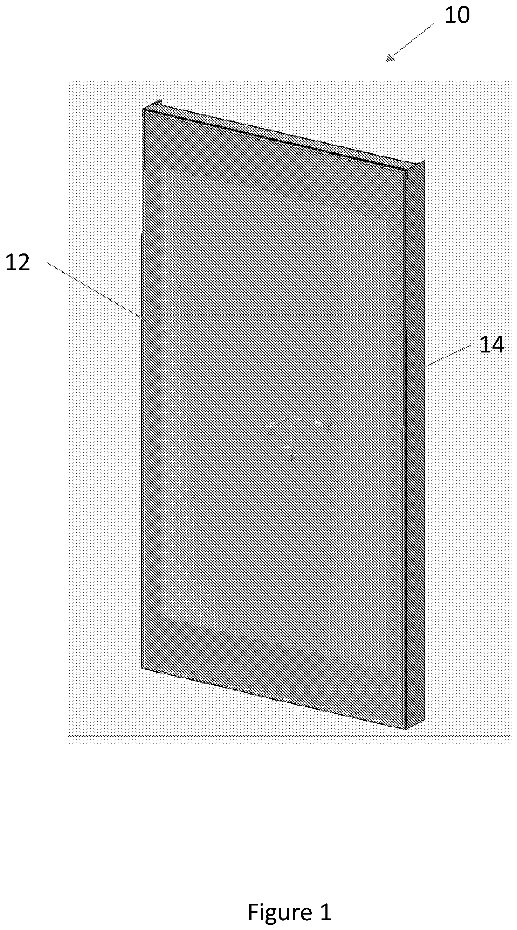

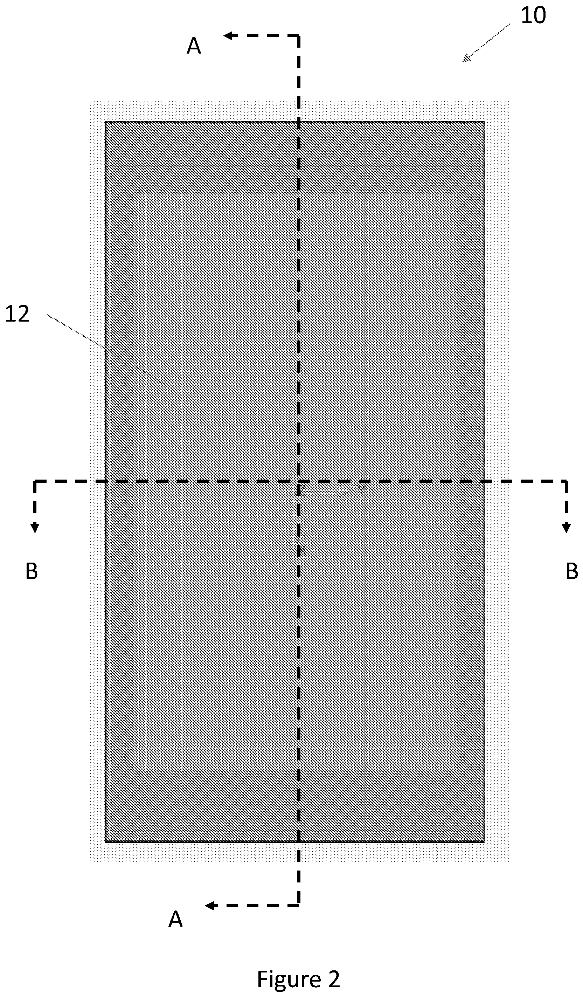

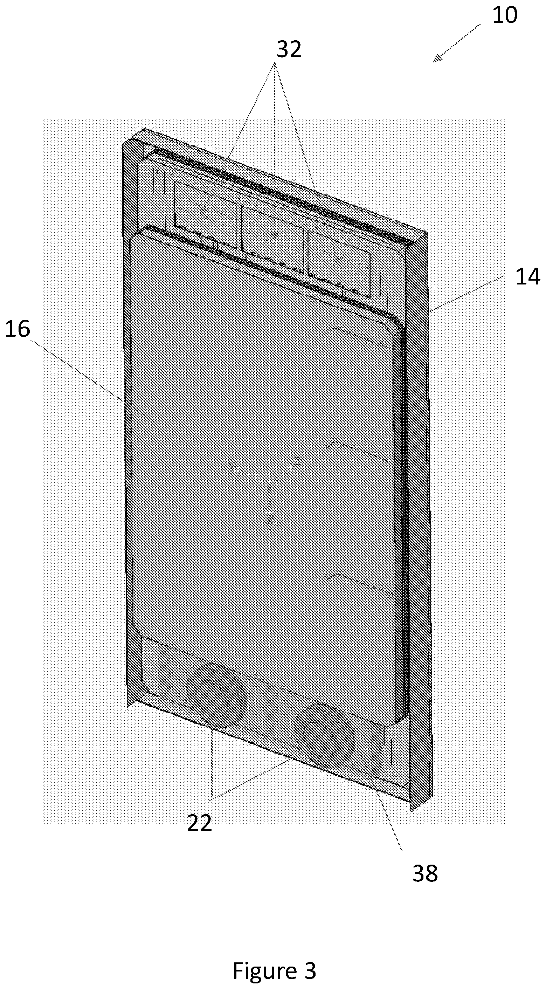

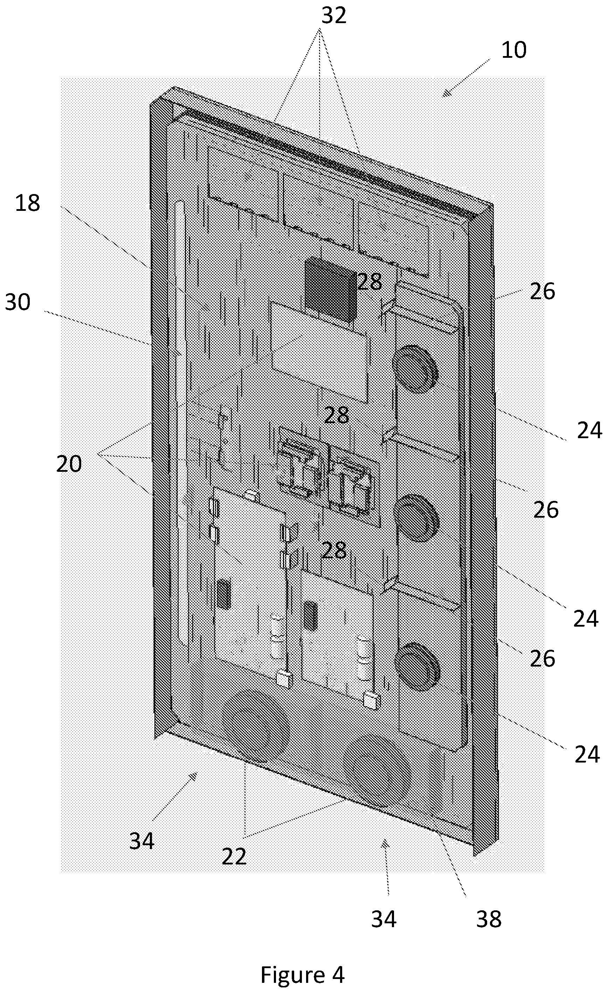

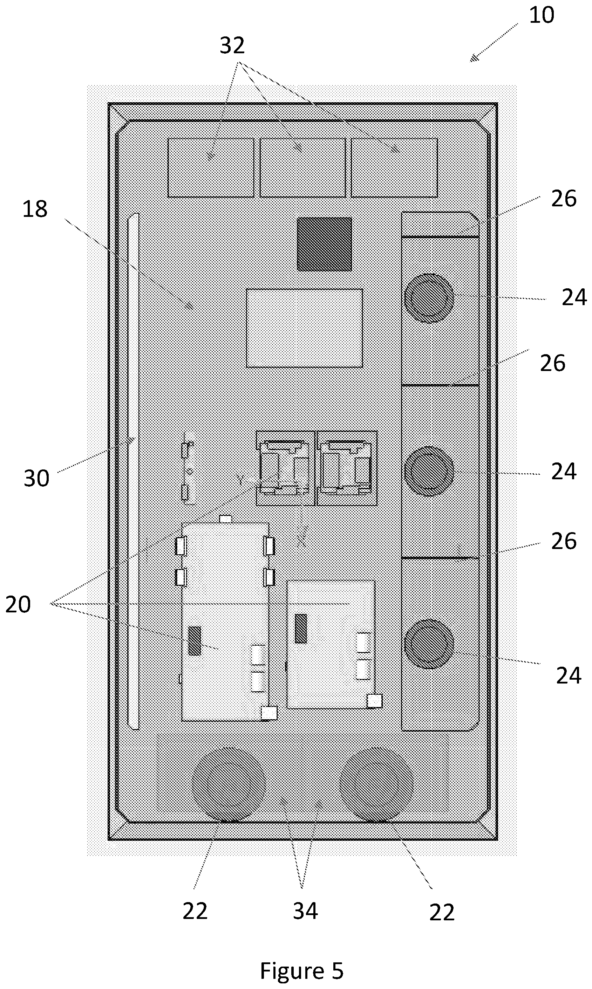

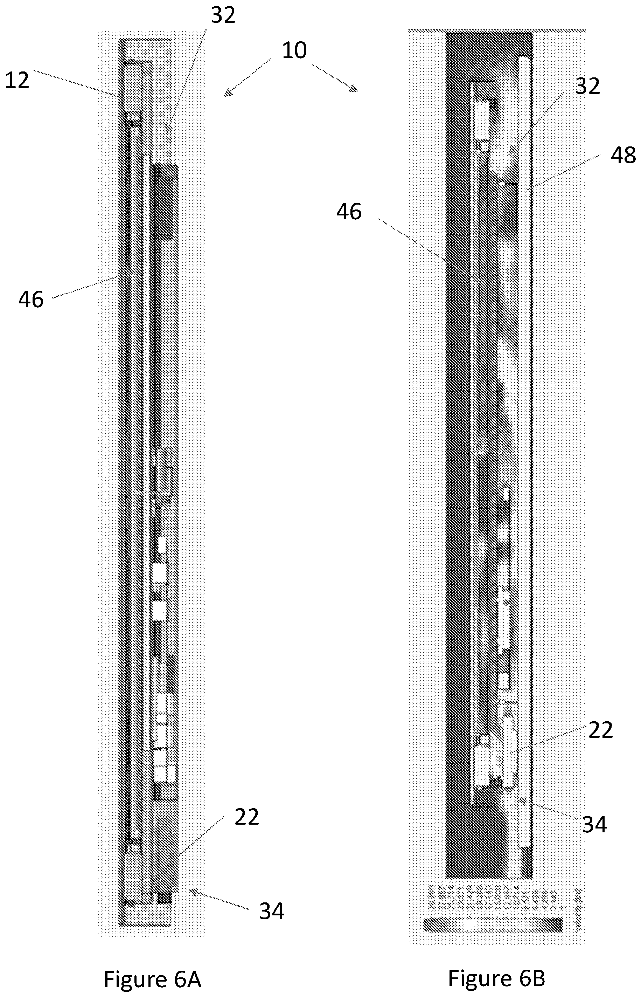

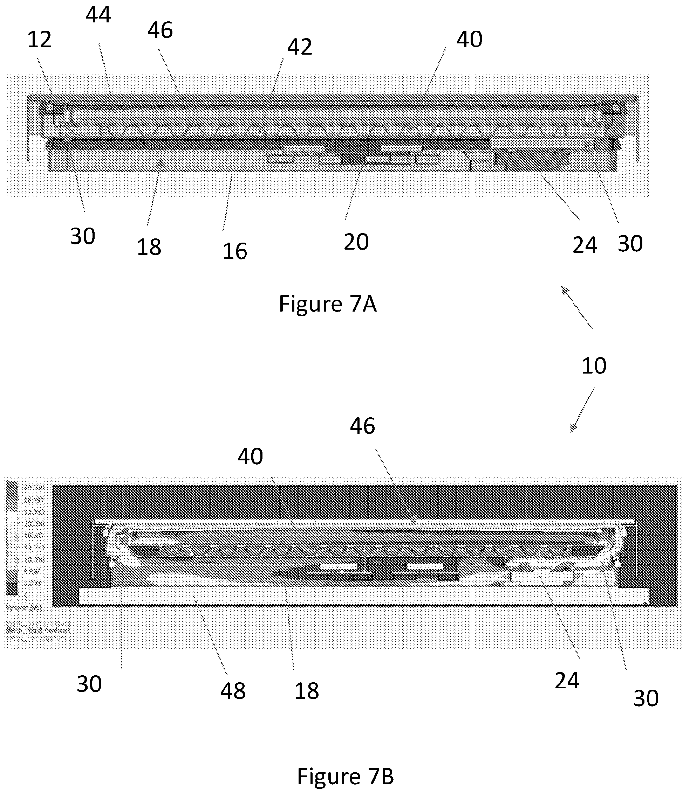

**FIGURE 1** through **FIGURE 7B** illustrate a display assembly 10 not falling within the scope of the present invention. The display assembly 10 may comprise a cover 12. The cover 12 may comprise glass, acrylic, polymer, combinations thereof, or another material. In exemplary embodiments, the cover 12 may comprise multiple layers, though such is not required. The layers of the cover 12 may comprise, for example, without limitation, a polarizer (linear, circular, etc.), an anti-reflective film, an optical adhesive, some combination thereof, or the like.

The cover 12 may be located forward of, and/or may form a portion of, an electronic display subassembly 44. In exemplary embodiments, the electronic display subassembly 44 may comprise one or more display layers (which may comprise liquid crystals, though such is not required), one or more diffusion layers, a backlight (direct or edge lit), or the like. Any type of electronic display subassembly 44 may be utilized including, but not limited to, LCD, LED, OLED, cathode ray tube, plasma, some combination thereof, or the like. The electronic display subassembly 44 may be of any size, kind, or type. The electronic display subassembly 44 may be provided in any orientation, including, but not limited to, portrait and/or landscape. More than one electronic display subassembly 44 may be utilized. In such examples, more than one cover 12 may be utilized, though such is not required.

The cover 12 may be attached to a frame 14. In exemplary embodiments, the frame 14 may define a hollow, rectangular shape, though such is not required. The frame 14 may be configured for mounting to a ground surface (e.g., street, sidewalk, etc.), a structure 48 (e.g., wall, post, etc.), or the like.

The cover 12 may define a surface area at least as large as the electronic display subassembly 44. The cover 12 may extend parallel to said electronic display subassembly 44. A front gap 46 may be provided between the cover 12 and the electronic display subassembly 44. For example, the font gap 46 may be located between a rear surface of the cover 12 and the front surface of the electronic display subassembly 44.

A rear compartment 18 may be located rearward of the electronic display subassembly 44. The rear compartment 18 may be located between a rear cover 16 and the electronic display subassembly 44. In exemplary embodiments, the rear compartment 18 may be located between a forward surface of the rear cover 16 and a rear surface of the electronic display subassembly 44.

The rear compartment 18 may be in fluid communication with the front gap 46, such as by way of one or more side channels 30. In exemplary embodiments, a first side channel 30 may extend on a first side of the display assembly 10 and a second side channel 30 may extend on a second side of the display assembly 10 such that circulating gas may form a loop about at least a portion of the electronic display subassembly 44. The front gap 46, side channels 30, and rear compartment 18 may define a closed loop airflow pathway. The closed loop airflow pathway may encircle at least a portion of the electronic display subassembly 44, such as, but not limited to the display layer. The front gap 46, side channels 30, and rear compartment 18 may be entirely or substantially sealed to permit the continuous re-circulation of circulating gas, which may be substantially or entirely particulate free.

The circulating gas may be fully or partially isolated from ambient air. For example, without limitation, the circulating gas may comprise filtered ambient air which is recirculated one or more times. As another example, without limitation, the closed loop airflow pathway(s) may be separated from the open loop airflow pathway(s) such that the circulating gas is not permitted to substantially mix with the ambient air. However, a 100% hermetic type seal is not necessarily required between the closed loop airflow pathway(s) and the open loop airflow pathway(s) or ambient environment. Instead, the seal may be sufficient to meet one or more certain ingress protection code (IPC) standards, such as, but not limited to, IP65, IP67, or the like. The display assembly 110 may comprise one or more partitions, gaskets, walls, panels, combinations thereof, or the like, which provide separation between the ambient air in the open loop airflow pathway(s) and the circulation gas in the closed loop airflow pathway(s).

One or more electronic components 20 for operating the display assembly 10 may be located within the rear compartment 18. For example, the electronic components 20 may be located on the rear panel 16, the electronic display subassembly 44, or the like. Such electronic components 20 may comprise one or more processors, electronic storage devices, computing devices, network connectivity devices, computing devices, video players, power modules, combinations thereof, or the like.

One or more intakes 32 may be provided at the electronic display subassembly 44. The intakes 32 may be fluidly separated from the closed loop airflow pathway. The intakes 32 may be located above, or at least partially within but fluidly separated from, the rear compartment 18, though any location may be utilized. One or more exhausts 34 may be provided at the electronic display subassembly 44. The exhausts 34 may be fluidly separated from the closed loop airflow pathway. The exhausts 34 may be located below, or at least partially within but fluidly separated from, the rear compartment 18, though any location may be utilized. One or more interior channels 40 may extend between the intakes 32 and exhausts 34. The interior channels 40 may extend along a rear surface of a backlight of the electronic display subassembly 44, though such is not required. The interior channels 40 may comprise corrugation 42. The intakes 32, exhausts 34, and interior channels 40 may define an open loop airflow pathway. The intakes 32, exhausts 34, and interior channels 40 may be configured to receive ambient air. A shroud 38 may be provided about some or all of the intakes 32 and/or exhausts 34 to fluidly seal the intakes 32 and/or exhausts 34 from the rear compartment 18.

One or more open loop fans 22 may be provided along the open loop pathway. In exemplary embodiments, the open loop fans 22 are located adjacent to each of the exhausts 34. Each of the open loop fans 22 may comprise centrifugal fans oriented such that the gas flow inlet is oriented interior to the display assembly 10, such as immediately adjacent to an exit of the interior channel 40, and a discharge of the open loop fans 22 is adjacent to an ambient environment. In this way, a substantially 90 degree turn naturally required between the interior channels 40 and the exhaust 34 may be performed by the open loop fans 22. Furthermore, the placement and/or orientation of the open loop fans 22 may provide a thinner display assembly 10.

One or more closed loop fans 24 may be provided along the closed loop airflow pathway. In exemplary embodiments, the closed loop fans 24 are located within the rear compartment 18. The closed loop fans 24 may be positioned adjacent to one of the side channels 30. Each of the closed loop fans 24 may comprise centrifugal fans oriented such that the gas flow inlet is oriented towards the front gap 46, such as along a right side of the display assembly 10 when viewed from the rear, and a discharge of the closed loop fans 24 is configured to blow the circulating gas along the rear compartment 18. In this way, a substantially 90 degree turn naturally required between the front gap 46 and the rear compartment 18 may be performed by the closed loop fans 24. Furthermore, the placement and/or orientation of the closed loop fans 24 may provide a thinner display assembly 10. The closed loop fans 24 may further provide increased distribution of air within at least the rear compartment 18. For example, without limitation, the closed loop fans 24 may be centrifugal fans provided without certain customary shrouding, which may increase the number of directions the discharged air is distributed.

Dividers 26 may be positioned between at least some, or all, of the closed loop fans 24, though such dividers 26 are not required. The dividers 26 may provide some direction for airflow distribution through the rear compartment 18. Optionally, airflow deflection elements 28 may be positioned on distal ends of the dividers 26 or otherwise adjacent to the discharge of the closed loop fans 24 to further control airflow. The airflow deflection elements 28 may comprise plates with various surface features, angles, holes, any combination thereof, or the like to direct airflow.

**FIGURE 8** through **FIGURE 14** illustrate an exemplary display assembly 110 in accordance with the present invention. The same or the similar features may be numbered similarly but increased by 100 (e.g., 10 to 110). The display assembly 110 may comprise one or more side assemblies 111. In exemplary embodiments, a first side assembly 111 is positioned opposite a second side assembly 111, though any number and arrangement of side assemblies 111 may be utilized. Each side assembly 111 may, in exemplary embodiments, comprise a cover 112, an electronic display subassembly 144, a front gap 146, an interior channel 140, corrugation 142, and side channels 130. Common or dedicated intakes 132 and exhausts 134 may be provided for the various side assemblies 111 and may form part of the open loop pathway(s) through the display assembly 110. In exemplary embodiments, common intakes 132 and dedicated exhausts 134 are utilized. In other exemplary embodiments, separate intakes 132 and exhausts 134 are utilized so that each open loop airflow pathway has a dedicated airflow pathway. In this manner, ingested ambient air may remain entirely or substantially separated from one another while within the display assembly 10.

A common cavity 118 may be provided between two or more of the side assemblies 111 and may form part of a closed loop airflow pathway for each of the side assemblies 111. However, dedicated cavities 118 for each side assembly 111 may be utilized in other exemplary embodiments.

Electronic components 120 may be provided within the common cavity 118. For example, without limitation, such electronic components 120 may be provided at or along one or more of rear surfaces of the side assemblies 111. The common cavity 118, in exemplary embodiments, may be fluidly separated from ambient air. In this way, the electronic components 120 may be only exposed to circulating gas, which may be temperature controlled and/or kept substantially free of moisture, particulate, and/or other potential contaminants.

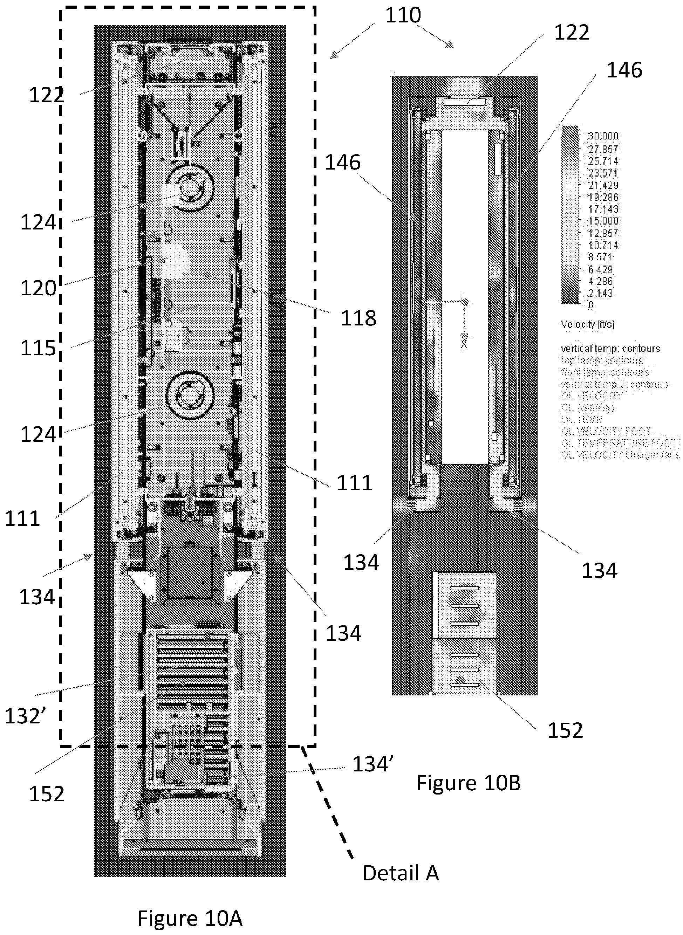

In exemplary embodiments, each side assembly 111 is moveably attached to a frame 114. Each of the open loop fans 122 are provided at or along an upper panel 113 at or along another panel of said frame 114. Said open loop fans 122 may be oriented such that a gas flow inlet faces upward to the ambient environment and a discharge portion is oriented to distribute ingested ambient air about the interior of the display assembly 10 for improved evenness of distribution to the side assemblies 111, as particularly illustrated with respect to figure 10B. In exemplary embodiments, the open loop fans 122 may comprise centrifugal fans lacking certain shrouding features such that air is partially or wholly distributed about the open loop fans 122 to provide more even distribution.

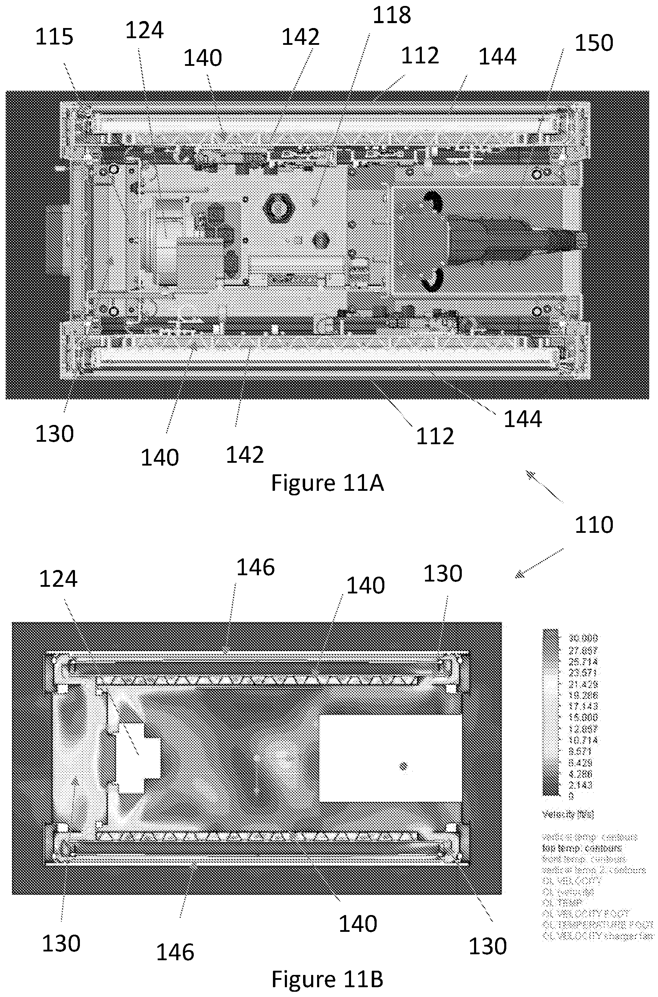

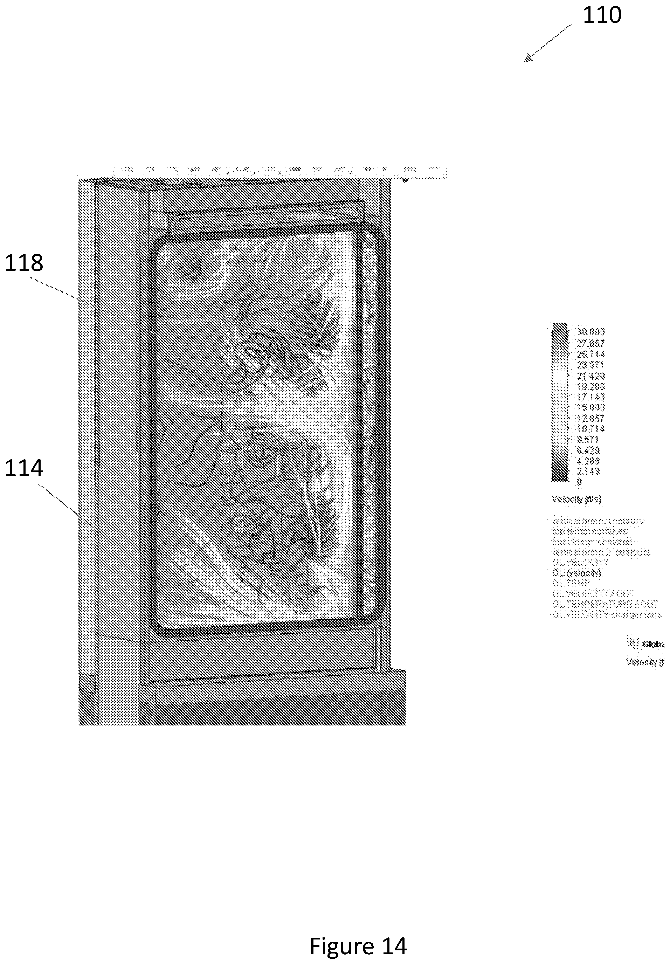

In exemplary embodiments, each of the closed loop fans 124 may be provided along a side panel 115 at or along said frame 114. Each of the closed loop fans 124 may be oriented such that the gas flow intake ingests air from the front gaps 146 of each of the side assemblies 111 and is discharged about the common cavity 118, as particularly illustrated with respect to figures 11B and 14. In exemplary embodiments, the closed loop fans 124 may comprise centrifugal fans lacking certain shrouding features such that air is partially or wholly distributed about the closed loop fans 124 to provide more even distribution.

Examples of centrifugal fans shown and/or described herein may include, for example, without limitation, those provided by Sanyo Denki Co. Ltd. having a US office in Torrance, California under the San Ace brand (https://products.sanyodenki.com/en/sanace/dc/centrifugal-fan/). Such centrifugal fans may be utilized in 150mm, 133mm, and/or 100mm to name a few examples, without limitation. The centrifugal fans may be provided without some or all of the certain conventional shroud elements such that air is discharged about some or all of the fans. This may improve air distribution. As such centrifugal fans are interior to the display assembly 110, user safety may not be impacted by removing such shrouding elements.

Provided herein are certain exemplary test results from use of such centrifugal fans, as compared to axial fans within certain exemplary display assemblies 10, 100. Such centrifugal fans may be provided as open loop fans 22 and/or closed loop fans 24.

**Table 1 - Centrifugal Fan Results**

| **centrifugal** | | | | | | |
|---|---|---|---|---|---|---|
| content | white | | | | | |
| ft/min | **ft/min** | **Zone** | **Zone Area (in2)** | **contributing area (in2)** | **contributing mass flow** | |
| | 470 | 1 | 28.27 | 7.0675 | 23.06753472 | same as 9 |
| 430 | 440 | 2 | 21.99 | 5.4975 | 16.79791667 | |
| 430 | 450 | 3 | 15.71 | 3.9275 | 12.2734375 | |
| 450 | 450 | 4 | 9.42 | 2.355 | 7.359375 | |
| 450 | 450 | 5 | 3.14 | 3.14 | 9.8125 | |
| 440 | 450 | 4 | 9.42 | 2.355 | 7.359375 | |
| 430 | 450 | 3 | 15.71 | 3.9275 | 12.2734375 | |
| 440 | 450 | 2 | 21.99 | 5.4975 | 17.1796875 | |
| 445 | 470 | 1 | 28.27 | 7.0675 | 23.06753472 | |
| | | | | | | |

| ft/min | **ft/min** | **Zone** | **Zone Area (in2)** | **contributing area (in2)** | **contributing mass flow** | |
|---|---|---|---|---|---|---|
| | 470 | 1 | 28.27 | 7.0675 | 23.06753472 | same as 9 |
| 415 | 415 | 2 | 21.99 | 5.4975 | 15.84348958 | |
| 425 | 430 | 3 | 15.71 | 3.9275 | 11.72795139 | |
| 430 | 430 | 4 | 9.42 | 2.355 | 7.032291667 | |
| 435 | 440 | 5 | 3.14 | 3.14 | 9.594444444 | |
| 440 | 450 | 4 | 9.42 | 2.355 | 7.359375 | |
| 440 | 450 | 3 | 15.71 | 3.9275 | 12.2734375 | |
| 440 | 460 | 2 | 21.99 | 5.4975 | 17.56145833 | |
| 440 | 470 | 1 | 28.27 | 7.0675 | 23.06753472 | |
| | | | | | | |
| | | | | | | |
| | | | | **Total Centrifugal Mass Flow** | **257** | |

**Table 2 - Axial Fan Results**

| **92** | | | | | |
|---|---|---|---|---|---|
| content | white | | | | |
| ft/min | **ft/min** | **Zone** | **Zone Area (in2)** | **contributing area (in2)** | **contributing mass flow** |
| | 460 | 1 | 28.27 | 7.0675 | 22.57673611 |
| 435 | 420 | 2 | 21.99 | 5.4975 | 16.034375 |
| 440 | 440 | 3 | 15.71 | 3.9275 | 12.00069444 |
| 460 | 450 | 4 | 9.42 | 2.355 | 7.359375 |
| 465 | 460 | 5 | 3.14 | 3.14 | 10.03055556 |
| 465 | 450 | 4 | 9.42 | 2.355 | 7.359375 |
| 460 | 460 | 3 | 15.71 | 3.9275 | 12.54618056 |
| 460 | 470 | 2 | 21.99 | 5.4975 | 17.94322917 |
| 450 | 460 | 1 | 28.27 | 7.0675 | 22.57673611 |
| | | | | | |

| ft/min | **ft/min** | **Zone** | **Zone Area (in2)** | **contributing area (in2)** | **contributing mass flow** |
|---|---|---|---|---|---|
| | 400 | 1 | 28.27 | 7.0675 | 19.63194444 |
| 440 | 450 | 2 | 21.99 | 5.4975 | 17.1796875 |
| 480 | 465 | 3 | 15.71 | 3.9275 | 12.68255208 |
| 480 | 460 | 4 | 9.42 | 2.355 | 7.522916667 |
| 475 | 460 | 5 | 3.14 | 3.14 | 10.03055556 |
| 460 | 430 | 4 | 9.42 | 2.355 | 7.032291667 |
| 420 | 410 | 3 | 15.71 | 3.9275 | 11.18246528 |
| 410 | 410 | 2 | 21.99 | 5.4975 | 15.65260417 |
| 400 | 400 | 1 | 28.27 | 7.0675 | 19.63194444 |
| | | | | | |
| | | | | | |
| | | | | **Total 92 Axial Mass Flow** | **249** |

As demonstrated from the above, better mass flow rate is achieved with the use of centrifugal fans. The use of such centrifugal fans also resulted in about four times less noise and about half the power usage as the axial fans. The presented testing results are for exemplary demonstration purposes and are in no way intended to be limiting.

In certain exemplary embodiments, electric vehicle charging equipment 150 may be provided at, or in association with, the display assemblies 10, 110. The electric vehicle charging equipment 150 in exemplary embodiments may be anchored to the frame 114 and/or the ground or other surface (directly or indirectly). The electric vehicle charging equipment 150 in exemplary embodiments may be electrically connected to the same power source as used to power the display assembly 10, 110, which may include utility power, battery power, solar power, combinations thereof, or the like. Some or all of the electric vehicle charging equipment 150 may be located between the side assemblies 111, though some or all of the electric vehicle charging equipment 150 may be located elsewhere.

The frame 114 may be adapted to accommodate the electrical vehicle charging equipment 150. For example, without limitation, the frame 114 may comprise a recessed portion comprising, or configured to accommodate, a housing 151 for at least some of the electric vehicle charging equipment 150 that extends into a portion of the cavity 118. The electric vehicle charging equipment 150 may be fully or partially recessed when a handle or other electric vehicle connection portion of the electric vehicle charging equipment 150 is docked at the display assembly 110 (e.g., not in use), such as at a receiver at or within the housing 151. For example, without limitation, a cord and/or the handle portion of the electric vehicle charging equipment 150 may extend from the frame 114 and/or outside of the housing 151. In exemplary embodiments, the electrical vehicle charging equipment 150 may be attached to a portion of the frame 114 extending between the side assemblies 111 such that the electrical vehicle charging equipment 150 is accessible from the side. Placing the electrical vehicle charging equipment 150 between the side assemblies 111 may result in a shorter overall height of the display assembly 110 which may be particularly advantageous for shipping.

One or more separate intakes/exhausts 132/134 and open and/or closed loop airflow pathways may be provided for some or all of the electric vehicle charging equipment 150, though such is not required. For example, some or all of the electric vehicle charging equipment 150 may have a dedicated open loop airflow pathway separate from other open loop airflow pathways for the display assembly 110. Alternatively, or additionally, the airflow for the electric vehicle charging equipment 150 may share one or more common intakes/exhausts 132/134 and open and/or closed loop airflow pathways with the side assemblies 111. For example, some or all of the electric vehicle charging equipment 150 may share an open loop airflow pathway with at least one of the side assemblies 111. Alternatively, or additionally, some or all of the electric vehicle charging equipment 150 may be thermally managed, at least in part, by the circulating gas within the common cavity 118. For example, without limitation, the circulating gas within the common cavity 118 may pass over interior surfaces of the housing 151 that extend within the common cavity 118, and/or certain power or other electronic components mounted at such interior surfaces of the housing 151 or otherwise within the common cavity 118.

The display assembly 110 may be configured to accommodate one or multiple electric vehicle chargers and related equipment 150. The display assembly 110 may be configured to accommodate various sizes and/or types of electric vehicle chargers and related equipment 150 positioned at various locations of the display assembly 110. For example, without limitation, electric vehicle connector portions (e.g., handles, plugs, outlets, adapters, connectors, or other components for docking with electric vehicles) may be provided at each side of the display assembly 110 for connecting with EV to charge the EV.

One or more additional equipment cavities 152 may be provided below, above, and/or adjacent to the side assemblies 111. For example, without limitation, a single additional equipment cavity 152 may be provided below, and at least partially between, the side assemblies 111. Electronic components 120 may be provided within the additional equipment cavity or cavities 152. Such electronic components 120 may comprise, for example, without limitation, components for operating the side assemblies 111 (e.g., electronic storage devices, processors, video players, network connectivity devices, power supplies, sensors, combinations thereof, or the like), components of, or for operating, the electric vehicle charging equipment 150 (e.g., power supplies, power transformers, capacitors, charge load centers, power meters, wiring, cords, handles, adapters, etc.), customer equipment or components for operating the same (e.g., network connectivity devices, cameras, sensors, microphones, telephonic equipment, emergency beacons, etc.), combinations thereof, or the like. More than one additional equipment cavity 152 at more than one location may be provided.

Some or all of the additional equipment cavities 152 may comprise shared or dedicated thermal management and/or power supplies with the side assemblies 111. In exemplary embodiments, without limitation, one or more separate intakes 132 and exhausts 134 are provided to facilitate a dedicated open loop airflow pathway through the additional equipment cavity 152. In other exemplary embodiments, without limitation, the additional equipment cavity 152 may share intakes 132 and/or exhausts 134 with one or more of the side assemblies 111, or otherwise form part of the open loop airflow pathways for the side assemblies 111.

Some or all of the electric vehicle ("EV") charging equipment 150 may be fully or partially recessed between the side assemblies 111. The EV charging equipment 150 may be connected, directly or indirectly, to the frame 114 and/or the side assemblies 111. Certain components of the EV charging equipment 150, such as, but not limited to, handles, connectors, adapters, cords, holsters, docks, combinations thereof, or the like may be fully or partially external to the display assembly 110. External components of the EV charging equipment 150 may be provided at, outside of, or connected to, exterior surfaces of a housing 151. The housing 151 may be fully or partially recessed into the common cavity 118 between the side assemblies 111. The size and/or shape of the housing 151 may be configured to accommodate various types or kinds of EV charging equipment 150. Certain components of the EV charging equipment 150, such as, but not limited to, power supplies, power regulators, transformers, power meters, batteries, electric grid connectors, combinations thereof, or the like may be fully or partially internal to the display assembly 110. Internal components of the EV charging equipment 150 may be provided within or at the side assemblies 111 and/or the additional equipment cavity or cavities 152. The additional equipment cavity 152 may comprise one or more ambient air pathways, which may be dedicated or form part of other open loop airflow pathways within the display assemblies 110. For example, without limitation, the additional equipment cavity 152 may comprise its own intake 132' and may utilize one or more of the exhausts 134 utilized by the side assemblies 111. As another example, without limitation, the additional equipment cavity 152 may comprise its own dedicated intake 132' and its own dedicated exhaust 134' such that ambient air circulating about the EV charging equipment 150 and/or other components in the additional equipment cavity 152 is kept separate from other open loop air.

The EV charging equipment 150 may comprise any type or kind of EV charger and associated equipment, such as but not limited to a level 2 charger.

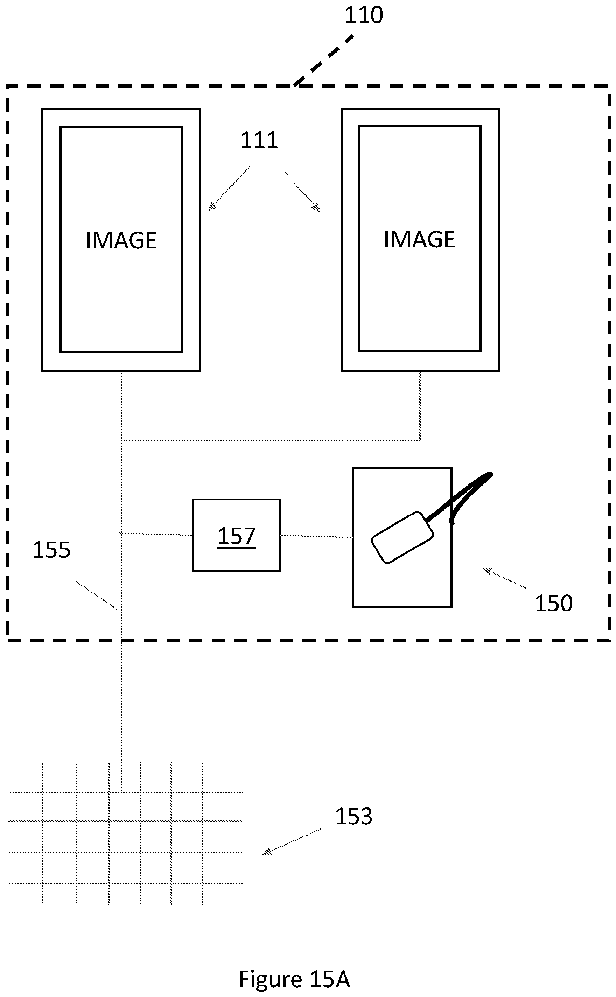

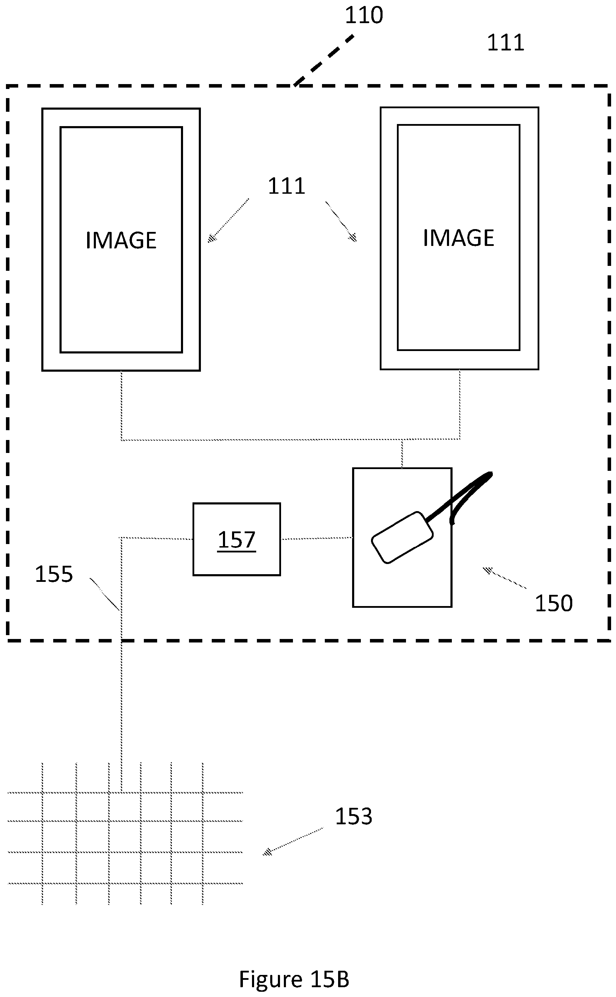

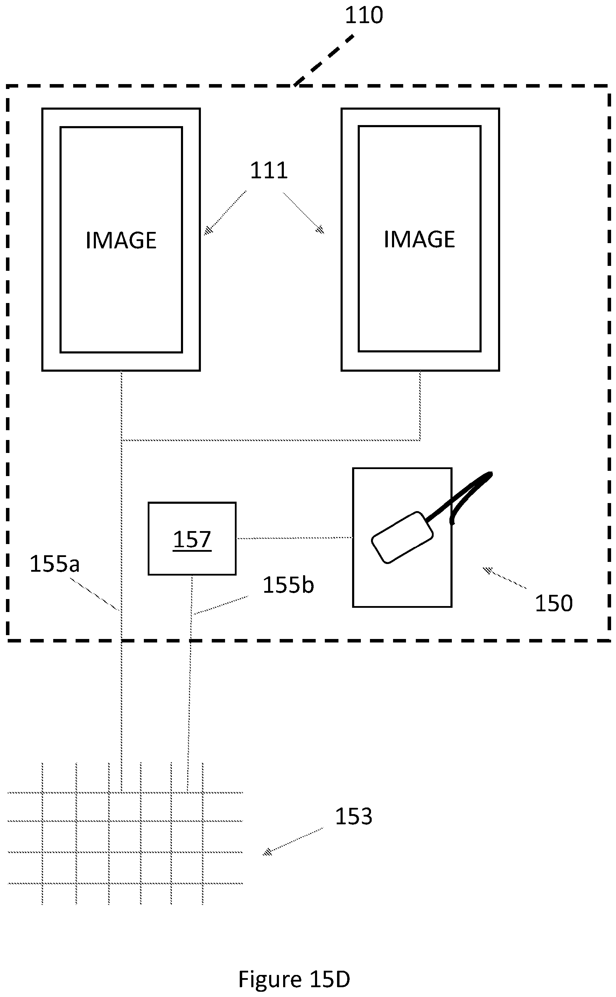

**FIGURE 15A** through **FIGURE 15D** illustrate various electrical schematics suitable for the display assemblies 110. The side assemblies 111 and the EV charging equipment 150 may be connected to a common power supply 153, such as, but not limited to, the electrical grid, solar panels, wind turbines, power generators, combinations thereof, or the like. Such electronic connection to the power supply 153 may be made by way of a common connection point or line 155, such as shown with particular regard to figures 15A-15C, or separate connection points or lines 155a, 155b, to the same or different power supplies 153, such as shown with particular regard to figure 15D. The EV charging equipment 150 may comprise any number of EV electric vehicle connector portions for any number or type of electric vehicles.

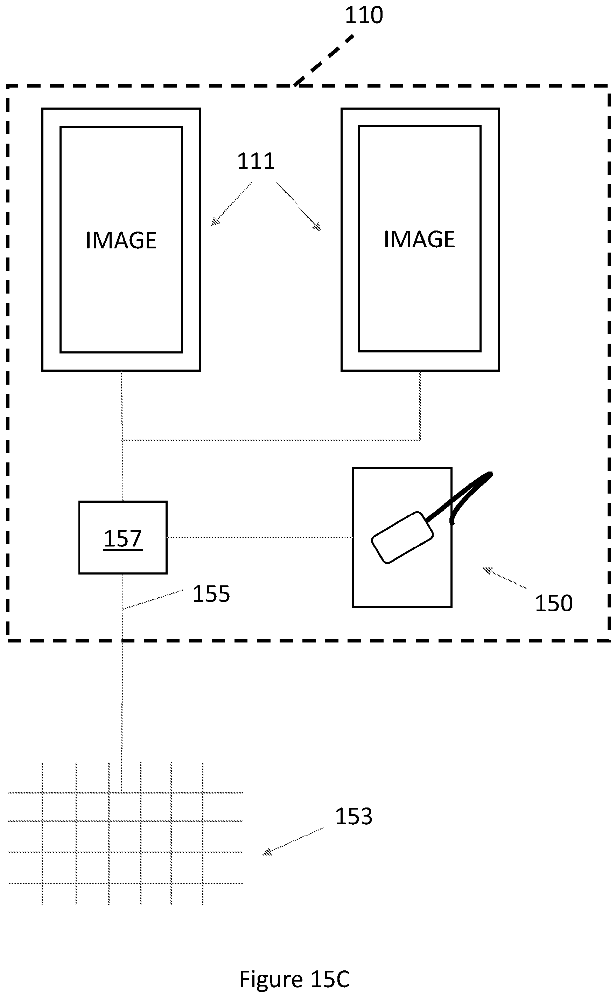

Optionally, one or more bulk energy storage devices 157, such as, but not limited to, one or more batteries, may be utilized with the display assemblies 110. The bulk energy storage devices 157 may be part of the EV charging equipment 150 or separate therefrom. In exemplary embodiments, the bulk energy storage devices 157 are electrically interposed between an electric vehicle connector portion of the EV charging equipment 150 and the power supply 153, though such is not required. In other exemplary embodiments, such as shown with particular regard to figure 15C, the bulk energy storage devices 157 may be electrically interposed between the electric vehicle connector portions of the EV charging equipment 150 and the side assemblies 111. The bulk energy storage devices 157 may act as the power supply 153 and/or a supplementary and/or alternative power supply 153 in exemplary embodiments.

One example of such EV charging equipment 150 includes, for example without limitation, electric vehicle chargers and related equipment provided available from ChargePoint, Inc. of Campbell, California (https://www.chargepoint.com/). Another example of such EV charging equipment 150 includes, for example without limitation, electric vehicle chargers and related equipment available from by EV-Box North America Inc. of Libertyville, Illinois (https://evbox.com/us-en/).

The housing 151 may be fully or partially enclosed in a manner which fully or partially seals an interior space of the housing 151 from ambient air. For example, without limitation, the housing 151 may comprise one or more enclosures conforming to one or more environmental protection ratings, such as but not limited to, National Electrical Manufacturer Association (NEMA) 1, 2, 3, 3R, 3X, 3RX, 3S, 3SX, 4, 4X, 5, 6, 6P, 12, 12K and/or 13.

The housing 151 may extend entirely or partially within the frame 114. The housing 151 may extend entirely or partially outside of the frame 114. The housing 151 may be connected, directly or indirectly, to the frame 115. The housing 151 may be provided as, as part of, or within, the additional equipment cavity 152.

In exemplary embodiments, without limitation, some or all of the EV charging equipment 150 may be provided within the housing 151. However, one or more electrical power supply lines may extend through the housing 151 and/or the frame 114 to connect with other electrical power supply lines for the subassemblies 111 and/or other components of the display assemblies 110, such as to provide the common connection line or point 155 to the power supply or supplies 153, though such is not required.

Any embodiment of the present invention may include any of the features of the other embodiments of the present invention. The exemplary embodiments herein disclosed are not intended to be exhaustive or to unnecessarily limit the scope of the invention. The exemplary embodiments were chosen and described in order to explain the principles of the present invention so that others skilled in the art may practice the invention. Having shown and described exemplary embodiments of the present invention, those skilled in the art will realize that many variations and modifications may be made to the described invention. Many of those variations and modifications will provide the same result and fall within the scope of the claimed invention. It is the intention, therefore, to limit the invention only as indicated by the scope of the claims.

Certain operations described herein may be performed by one or more electronic devices. Each electronic device may comprise one or more processors, electronic storage devices, executable software instructions, and the like configured to perform the operations described herein. The electronic devices may be general purpose computers or specialized computing devices. The electronic devices may comprise personal computers, smartphones, tablets, databases, servers, or the like. The electronic connections and transmissions described herein may be accomplished by wired or wireless means. The computerized hardware, software, components, systems, steps, methods, and/or processes described herein may serve to improve the speed of the computerized hardware, software, systems, steps, methods, and/or processes described herein.

## Claims

1. A display assembly (10) with integrated electric vehicle charging equipment (150), said display assembly comprising:
a structural frame (114);
a first side assembly (111) connected to a first side of said structural frame, said first side assembly comprising a first cover (112) and a first electronic display subassembly (144) located behind said first cover;
a second side assembly (111) connected to a second side of said structural frame, said second side assembly comprising a second cover (112) and a second electronic display subassembly (144) located behind said second cover;
**characterized in that** a common cavity (118) is located between the first side assembly and the second side assembly;
a housing (151) extending inward from the structural frame into the common cavity to at least partially recess said housing; and
said electric vehicle charging equipment (150), wherein said electric vehicle charging equipment is connected to said structural frame between said first side assembly and said second side assembly, and wherein external components of said electric vehicle charging equipment are located at said housing for storage in a recessed manner.

2. The display assembly of claim 1 wherein:
said electric vehicle charging equipment is fully recessed between said first side assembly and said second side assembly when an electric vehicle connector portion for said electric vehicle charging equipment is docked at the display assembly.

3. The display assembly of claim 1 further comprising:
a closed loop airflow pathway for circulating gas comprising a first portion extending within said first side assembly, a second portion extending within said second side assembly, and said common cavity.

4. The display assembly of claim 3 further comprising:
at least one loop airflow pathway for ambient air.

5. The display assembly of claim 4 wherein:
said at least one open loop airflow pathway comprises a first open loop airflow pathway extending through said first side assembly and a second open loop airflow pathway extending through said second side assembly.

6. The display assembly of claim 5 further comprising:
a common intake for said first open loop airflow pathway and said second open loop airflow pathway located at an upper portion of said first and second side assemblies;
a first exhaust for said first open loop airflow pathway;
a second exhaust for said second open loop airflow pathway; and
a common set of open loop fans located adjacent to said common intake, wherein said common set of open loop fans comprise centrifugal type fans oriented to distribute ingested ambient air into both of said first open loop airflow pathway and said second open loop airflow pathway when operated.

7. The display assembly of claim 6 wherein:
each of said centrifugal type fans of said common set of open loop fans are provided without a shroud.

8. The display assembly of claim 6 further comprising:
a set of one or more closed loop fans located within said common cavity for moving circulating gas through said closed loop airflow pathway when operated.

9. The display assembly of claim 8 further comprising:
a side panel located within said common cavity and oriented perpendicular to a front surface of said first side assembly and a front surface of said second side assembly, wherein each fan in said set of one or more closed loop fans comprises a centrifugal type fan spaced apart vertically along said side panel.

10. The display assembly of claim 5 wherein:
said first electronic display subassembly comprises a first LCD display layer and a first backlight;
said second electronic display subassembly comprises a second LCD display layer and a second backlight;
said first open loop airflow pathway extends directly adjacent to the first backlight; and
said second open loop airflow pathway extends directly adjacent to the second backlight.

11. The display assembly of claim 10 wherein:
said first portion of said closed loop airflow pathway is located between said first cover and said first LCD display layer of said first electronic display subassembly; and
said second portion of said closed loop airflow pathway is located between said second cover and said second LCD display layer of said second electronic display subassembly.

12. The display assembly of claim 1 further comprising:
an additional equipment cavity located below, and at least partially between, said first side assembly and said second side assembly; and
one or more internal components of said electric vehicle charging equipment located within said additional equipment cavity.

13. The display assembly of claim 12 further comprising:
a dedicated open loop airflow pathway through said additional equipment cavity.

14. The display assembly of claim 1 further comprising:
a first gasket provided at said structural frame between said structural frame and said first side assembly, wherein said first side assembly is moveably connected to said structural frame between a closed position where said first gasket is compressed between said first side assembly and said structural frame and an open position where an edge of said first side assembly is rotated away from said structural frame; and
a second gasket provided at said structural frame between said structural frame and said second side assembly, wherein said second side assembly is moveably connected to said structural frame between a closed position where said second gasket is compressed between said second side assembly and said structural frame and an open position where an edge of said second side assembly is rotated away from said structural frame.

15. The display assembly of claim 1 further comprising:
a common power source for said first side assembly, said second side assembly, and said electric vehicle charging equipment.

## Patentansprüche

1. Anzeigebaugruppe (10) mit integrierter Elektrofahrzeug-Ladeeinrichtung (150), wobei die Anzeigebaugruppe Folgendes umfasst:
einen Strukturrahmen (114);
eine erste Seitenbaugruppe (111), die mit einer ersten Seite des Strukturrahmens verbunden ist, wobei die erste Seitenbaugruppe eine erste Abdeckung (112) und eine erste elektronische Anzeigeunterbaugruppe (144) umfasst, die sich hinter der ersten Abdeckung befindet;
eine zweite Seitenbaugruppe (111), die mit einer zweiten Seite des Strukturrahmens verbunden ist, wobei die zweite Seitenbaugruppe eine zweite Abdeckung (112) und eine zweite elektronische Anzeigeunterbaugruppe (144) umfasst, die sich hinter der zweiten Abdeckung befindet;
**dadurch gekennzeichnet, dass** sich zwischen der ersten Seitenbaugruppe und der zweiten Seitenbaugruppe ein gemeinsamer Hohlraum (118) befindet;
ein Gehäuse (151), das von dem Strukturrahmen nach innen in den gemeinsamen Hohlraum verläuft, um das Gehäuse mindestens teilweise zu vertiefen; und
die Elektrofahrzeug-Ladeeinrichtung (150), wobei die Elektrofahrzeug-Ladeeinrichtung mit dem Strukturrahmen zwischen der ersten Seitenbaugruppe und der zweiten Seitenbaugruppe verbunden ist, und wobei sich externe Komponenten der Elektrofahrzeug-Ladeeinrichtung in einer vertieften Weise zur Lagerung an dem Gehäuse befinden.

2. Anzeigebaugruppe nach Anspruch 1, wobei:
die Elektrofahrzeug-Ladeeinrichtung vollständig zwischen der ersten Seitenbaugruppe und der zweiten Seitenbaugruppe vertieft ist, wenn ein Elektrofahrzeug-Verbindungsabschnitt für die Elektrofahrzeug-Ladeeinrichtung an der Anzeigebaugruppe angedockt ist.

3. Anzeigebaugruppe nach Anspruch 1, ferner umfassend:
einen Luftströmungsweg mit geschlossenem Kreislauf zum Zirkulieren von Gas, der einen ersten Abschnitt, der innerhalb der ersten Seitenbaugruppe verläuft, einen zweiten Abschnitt, der innerhalb der zweiten Seitenbaugruppe verläuft, und den gemeinsamen Hohlraum umfasst.

4. Anzeigebaugruppe nach Anspruch 3, ferner umfassend:
mindestens einen Kreislauf-Luftströmungsweg für Umgebungsluft.

5. Anzeigebaugruppe nach Anspruch 4, wobei:
der mindestens eine Luftströmungsweg mit offenem Kreislauf einen ersten Luftströmungsweg mit offenem Kreislauf umfasst, der durch die erste Seitenbaugruppe verläuft, und einen zweiten Luftströmungsweg mit offenem Kreislauf, der durch die zweite Seitenbaugruppe verläuft.

6. Anzeigebaugruppe nach Anspruch 5, ferner umfassend:
einen gemeinsamen Einlass für den ersten Luftströmungsweg mit offenem Kreislauf und den zweiten Luftströmungsweg mit offenem Kreislauf, der sich an einem oberen Abschnitt der ersten und zweiten Seitenbaugruppe befindet;
einen ersten Auslass für den ersten Luftströmungsweg mit offenem Kreislauf;
einen zweiten Auslass für den zweiten Luftströmungsweg mit offenem Kreislauf; und
einen gemeinsamen Satz von Gebläsen mit offenem Kreislauf, die sich zu dem gemeinsamen Einlass benachbart befinden, wobei der gemeinsame Satz von Gebläsen mit offenem Kreislauf Zentrifugaltyp-Gebläse umfasst, die ausgerichtet sind, um angesaugte Umgebungsluft beim Betreiben sowohl in den ersten Luftströmungsweg mit offenem Kreislauf als auch in den zweiten Luftströmungsweg mit offenem Kreislauf zu verteilen.

7. Anzeigebaugruppe nach Anspruch 6, wobei:
jedes der Zentrifugaltyp-Gebläse des gemeinsamen Satzes von Gebläsen mit offenem Kreislauf ohne Abdeckhaube bereitgestellt ist.

8. Anzeigebaugruppe nach Anspruch 6, ferner umfassend:
einen Satz von einem oder mehreren Gebläsen mit geschlossenem Kreislauf innerhalb des gemeinsamen Hohlraums, zur Bewegung von zirkulierendem Gas durch den Luftströmungsweg mit geschlossenem Kreislauf beim Betreiben.

9. Anzeigebaugruppe nach Anspruch 8, ferner umfassend:
eine Seitenwand, die sich in dem gemeinsamen Hohlraum befindet und senkrecht zu einer vorderen Fläche der ersten Seitenbaugruppe und einer vorderen Fläche der zweiten Seitenbaugruppe ausgerichtet ist, wobei jedes Gebläse in dem Satz von einem oder mehreren Gebläsen mit geschlossenem Kreislauf ein Zentrifugaltyp-Gebläse umfasst, das vertikal entlang der Seitenwand beabstandet ist.

10. Anzeigebaugruppe nach Anspruch 5, wobei:
die erste elektronische Anzeigeunterbaugruppe eine erste LCD-Anzeigeschicht und eine erste Hintergrundbeleuchtung umfasst;
die zweite elektronische Anzeigeunterbaugruppe eine zweite LCD-Anzeigeschicht und eine zweite Hintergrundbeleuchtung umfasst;
der erste Luftströmungsweg mit offenem Kreislauf direkt benachbart zu der ersten Hintergrundbeleuchtung verläuft; und
der zweite Luftströmungsweg mit offenem Kreislauf direkt benachbart zu der zweiten Hintergrundbeleuchtung verläuft.

11. Anzeigebaugruppe nach Anspruch 10, wobei:
sich der erste Abschnitt des Luftströmungswegs mit geschlossenem Kreislauf zwischen der ersten Abdeckung und der ersten LCD-Anzeigeschicht der ersten elektronischen Anzeigeunterbaugruppe befindet; und
sich der zweite Abschnitt des Luftströmungswegs mit geschlossenem Kreislauf zwischen der zweiten Abdeckung und der zweiten LCD-Anzeigeschicht der zweiten elektronischen Anzeigeunterbaugruppe befindet.

12. Anzeigebaugruppe nach Anspruch 1, ferner umfassend:
einen zusätzlichen Einrichtungshohlraum, der sich unter und mindestens teilweise zwischen der ersten Seitenbaugruppe und der zweiten Seitenbaugruppe befindet; und
eine oder mehrere interne Komponenten der Elektrofahrzeug-Ladeeinrichtung, die sich in dem zusätzlichen Einrichtungshohlraum befinden.

13. Anzeigebaugruppe nach Anspruch 12, ferner umfassend:
einen speziellen Luftströmungsweg mit offenem Kreislauf durch den zusätzlichen Einrichtungshohlraum.

14. Anzeigebaugruppe nach Anspruch 1, ferner umfassend:
eine erste Dichtung, die an dem Strukturrahmen zwischen dem Strukturrahmen und der ersten Seitenbaugruppe bereitgestellt ist, wobei die erste Seitenbaugruppe beweglich mit dem Strukturrahmen zwischen einer geschlossenen Position, in der die erste Dichtung zwischen der ersten Seitenbaugruppe und dem Strukturrahmen zusammengedrückt ist, und einer offenen Position, in der eine Kante der ersten Seitenbaugruppe von dem Strukturrahmen weggedreht ist, verbunden ist; und
eine zweite Dichtung, die an dem Strukturrahmen zwischen dem Strukturrahmen und der zweiten Seitenbaugruppe bereitgestellt ist, wobei die zweite Seitenbaugruppe beweglich mit dem Strukturrahmen zwischen einer geschlossenen Position, in der die zweite Dichtung zwischen der zweiten Seitenbaugruppe und dem Strukturrahmen zusammengedrückt ist, und einer offenen Position, in der eine Kante der zweiten Seitenbaugruppe von dem Strukturrahmen weggedreht ist, verbunden ist.

15. Anzeigebaugruppe nach Anspruch 1, ferner umfassend:
eine gemeinsame Stromquelle für die erste Seitenbaugruppe, die zweite Seitenbaugruppe und die Elektrofahrzeug-Ladeeinrichtung.

## Revendications

1. Ensemble d'affichage (10) avec équipement de charge intégré pour véhicule électrique (150), ledit ensemble d'affichage comprenant :
un cadre structurel (114) ;
un premier ensemble latéral (111) relié à un premier côté dudit cadre structurel, ledit premier ensemble latéral comprenant un premier couvercle (112) et un premier sous-ensemble d'affichage électronique (144) situé derrière ledit premier couvercle ;
un second ensemble latéral (111) relié à un second côté dudit cadre structurel, ledit second ensemble latéral comprenant un second couvercle (112) et un second sous-ensemble d'affichage électronique (144) situé derrière ledit second couvercle ;
**caractérisé en ce qu'**une cavité commune (118) est située entre le premier ensemble latéral et le second ensemble latéral ;
un boîtier (151) s'étendant vers l'intérieur à partir du cadre structurel dans la cavité commune pour enfoncer au moins partiellement ledit boîtier ; et
ledit équipement de charge pour véhicule électrique (150), dans lequel ledit équipement de charge de véhicule électrique est connecté audit cadre structurel entre ledit premier ensemble latéral et ledit second ensemble latéral, et dans lequel des composants externes dudit équipement de charge pour véhicule électrique sont situés dans ledit boîtier pour être stockés de manière encastrée.

2. Ensemble d'affichage selon la revendication 1, dans lequel : ledit équipement de charge pour véhicule électrique est entièrement encastré entre ledit premier ensemble latéral et ledit second ensemble latéral lorsqu'une partie de connecteur de véhicule électrique pour ledit équipement de charge pour véhicule électrique est connectée à l'ensemble d'affichage.

3. Ensemble d'affichage selon la revendication 1, comprenant en outre :
un chemin d'écoulement d'air en boucle fermée pour faire circuler du gaz comprenant une première partie s'étendant à l'intérieur dudit premier ensemble latéral, une seconde partie s'étendant à l'intérieur dudit second ensemble latéral et ladite cavité commune.

4. Ensemble d'affichage selon la revendication 3, comprenant en outre :
au moins un chemin d'écoulement d'air en boucle pour l'air ambiant.

5. Ensemble d'affichage selon la revendication 4, dans lequel : ledit au moins un chemin d'écoulement d'air en boucle ouverte comprend un premier chemin d'écoulement d'air en boucle ouverte s'étendant à travers ledit premier ensemble latéral et un second chemin d'écoulement d'air en boucle ouverte s'étendant à travers ledit second ensemble latéral.

6. Ensemble d'affichage selon la revendication 5, comprenant en outre :
une admission commune pour ledit premier chemin d'écoulement d'air en boucle ouverte et ledit second chemin d'écoulement d'air en boucle ouverte située dans une partie supérieure desdits premier et second ensembles latéraux ;
un premier échappement pour ledit premier chemin d'écoulement d'air en boucle ouverte ;
un second échappement pour ledit second chemin d'écoulement d'air en boucle ouverte ; et
un ensemble commun de ventilateurs à boucle ouverte situé à côté de ladite admission commune, ledit ensemble commun de ventilateurs à boucle ouverte comprenant des ventilateurs de type centrifuge orientés pour distribuer l'air ambiant ingéré dans ledit premier chemin d'écoulement d'air à boucle ouverte et ledit second chemin d'écoulement d'air à boucle ouverte lorsqu'ils sont en fonctionnement.

7. Ensemble d'affichage selon la revendication 6, dans lequel : chacun desdits ventilateurs de type centrifuge dudit ensemble commun de ventilateurs à boucle ouverte est fourni sans carénage.

8. Ensemble d'affichage selon la revendication 6, comprenant en outre :
un ensemble d'un ou plusieurs ventilateurs en boucle fermée situés à l'intérieur de ladite cavité commune pour déplacer le gaz en circulation à travers ledit chemin d'écoulement d'air en boucle fermée lorsqu'ils sont en fonctionnement.

9. Ensemble d'affichage selon la revendication 8, comprenant en outre :
un panneau latéral situé à l'intérieur de ladite cavité commune et orienté perpendiculairement à une surface avant dudit premier ensemble latéral et à une surface avant dudit second ensemble latéral, dans lequel chaque ventilateur dans ledit ensemble d'un ou plusieurs ventilateurs en boucle fermée comprend un ventilateur de type centrifuge espacé verticalement le long dudit panneau latéral.

10. Ensemble d'affichage selon la revendication 5, dans lequel :
ledit premier sous-ensemble d'affichage électronique comprend une première couche d'affichage LCD et un premier rétroéclairage ;
ledit second sous-ensemble d'affichage électronique comprend une seconde couche d'affichage LCD et un second rétroéclairage ;
ledit premier chemin d'écoulement d'air en boucle ouverte s'étend directement à côté du premier rétroéclairage ; et
ledit second chemin d'écoulement d'air en boucle ouverte s'étend directement à côté du second rétroéclairage ; et

11. Ensemble d'affichage selon la revendication 10, dans lequel :
ladite première partie dudit chemin d'écoulement d'air en boucle fermée est située entre ledit premier couvercle et ladite première couche d'affichage LCD dudit premier sous-ensemble d'affichage électronique ; et
ladite seconde partie dudit chemin d'écoulement d'air en boucle fermée est située entre ledit second couvercle et ladite seconde couche d'affichage LCD dudit second sous-ensemble d'affichage électronique.

12. Ensemble d'affichage selon la revendication 1, comprenant en outre :
une cavité d'équipement supplémentaire située en dessous, et au moins partiellement entre, ledit premier ensemble latéral et ledit second ensemble latéral ; et
un ou plusieurs composants internes dudit équipement de charge pour véhicule électrique situés à l'intérieur de ladite cavité d'équipement supplémentaire.

13. Ensemble d'affichage selon la revendication 12, comprenant en outre :
un chemin de circulation d'air en boucle ouverte dédié à travers ladite cavité d'équipement supplémentaire.

14. Ensemble d'affichage selon la revendication 1, comprenant en outre :
un premier joint d'étanchéité prévu sur ledit cadre structurel entre ledit cadre structurel et ledit premier ensemble latéral, ledit premier ensemble latéral étant relié de manière mobile audit cadre structurel entre une position fermée où ledit premier joint est comprimé entre ledit premier ensemble latéral et ledit cadre structurel et une position ouverte où un bord dudit premier ensemble latéral est tourné à l'opposé dudit cadre structurel ; et
un second joint d'étanchéité prévu sur ledit cadre structurel entre ledit cadre structurel et ledit second ensemble latéral, ledit second ensemble latéral étant relié de manière mobile audit cadre structurel entre une position fermée où ledit second joint est comprimé entre ledit second ensemble latéral et ledit cadre structurel et une position ouverte où un bord dudit second ensemble latéral est tourné à l'opposé dudit cadre structurel.

15. Ensemble d'affichage selon la revendication 1, comprenant en outre :
une source d'alimentation commune pour ledit premier ensemble latéral, ledit second ensemble latéral et ledit équipement de charge pour véhicule électrique.
